(19) Europäisches Patentamt
European Patent Office
Office européen des brevets

(11) **EP 3 658 974 B1**

(12) **EUROPÄISCHE PATENTSCHRIFT**

(45) Veröffentlichungstag und Bekanntmachung des Hinweises auf die Patenterteilung:
**19.10.2022 Patentblatt 2022/42**

(21) Anmeldenummer: **18750365.1**

(22) Anmeldetag: **25.07.2018**

(51) Internationale Patentklassifikation (IPC):
*G02B 26/08* (2006.01)  *B81B 7/00* (2006.01)

(52) Gemeinsame Patentklassifikation (CPC):
**G02B 26/0833; B81B 7/0067;** B81B 2201/042

(86) Internationale Anmeldenummer:
**PCT/EP2018/070215**

(87) Internationale Veröffentlichungsnummer:
**WO 2019/020708 (31.01.2019 Gazette 2019/05)**

(54) **MEMS SPIEGELANORDNUNG UND VERFAHREN ZUR HERSTELLUNG EINER MEMS SPIEGELANORDNUNG**

MEMS MIRROR ASSEMBLY AND METHOD FOR PRODUCING A MEMS MIRROR ASSEMBLY

SYSTÈME DE MIROIR MEMS ET PROCÉDÉ DE FABRICATION D'UN SYSTÈME DE MIROIR MEMS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.07.2017 DE 102017213070**

(43) Veröffentlichungstag der Anmeldung:
**03.06.2020 Patentblatt 2020/23**

(73) Patentinhaber: **Fraunhofer-Gesellschaft zur Förderung
der angewandten Forschung e.V.
80686 München (DE)**

(72) Erfinder:
• **QUENZER, Hans Joachim
25524 Itzehoe (DE)**
• **HOFMANN, Ulrich
25524 Itzehoe (DE)**
• **STENCHLY, Vanessa
25704 Meldorf (DE)**

(74) Vertreter: **Pfenning, Meinig & Partner mbB
Patent- und Rechtsanwälte
Joachimsthaler Straße 10-12
10719 Berlin (DE)**

(56) Entgegenhaltungen:
WO-A1-01/38240          CN-A- 101 734 612
CN-B- 102 569 563      US-A1- 2007 071 922
US-A1- 2008 239 531    US-A1- 2015 131 034

EP 3 658 974 B1

**Beschreibung**

Die Erfindung betrifft eine MEMS Spiegelanordnung zum Erfassen eines großen Winkelbereichs und ein Verfahren zur Herstellung einer MEMS Spiegelanordnung.

MEMS Spiegelanordnungen, die beispielsweise als Scanner, in Projektoren, in Lidar (light detection and ranging) Systemen und dergleichen verwendet werden und die mindestens einen beispielsweise an Torsionsfedern ein- oder zweiachsig aufgehängten Spiegel aufweisen, sind im Stand der Technik allgemein bekannt und werden vorzugsweise auf Waferebene hergestellt, da die Montage einzelner mit einem Gehäuse versehener Spiegelanordnungen mit hohen Kosten verbunden ist. Dabei werden mehrere MEMS Bauelemente auf einem Wafer hergestellt, der in einem nachgeschalteten Arbeitsgang mit einem weiteren, eine Vielzahl von Gehäusedeckeln aufweisenden Wafer, beispielsweise durch Bonden, verbunden wird. Anschließend wird der Waferstapel beispielsweise durch Sägen in einzelne Bauelemente geteilt. Diese Vorgehensweise ermöglicht nicht nur ein sehr effizientes Packaging aller Bauelemente, sondern vereinfacht auch das Testen der Komponenten beträchtlich, da alle nötigen Tests noch auf Waferebene mit entsprechenden Waferprobern erfolgen können.

Während das Wafer-Levelpackaging (WLP) im Bereich mikromechanischer Sensoren mittlerweile zu einer Standardtechnologie avanciert ist, ist das Packaging optischer Komponenten und Systeme auf Waferebene immer noch vergleichsweise selten. Dies liegt vor allem an bislang nur eingeschränkten Möglichkeiten, kleine optische Gehäuse nach Funktionsaspekten zu gestalten bzw. allen Anforderungen von Optik, Elektronik und thermischem Management zu entsprechen. Bei der Verkappung optischer Komponenten und Systeme ergibt sich eine Reihe spezifischer Anforderungen, die sich direkt auf die Gestaltung und Orientierung der optischen Fensterflächen auswirken. So werden z.B. geneigte Fensterflächen immer dann benötigt, wenn Reflexionen Störungen auslösen. Aus der DE 10 2011119 610 ist beispielsweise ein Verfahren zur Herstellung strukturierter optischer Komponenten bekannt, bei dem das MEMS Packaging unter Verwendung von schrägen Gehäusefenstern verwendet wird.

Die Gehäuseformen für MEMS Spiegelanordnungen weisen üblicherweise optische Ein- und Austrittsfenster auf, die aus planen oder planparallelen Flächen aufgebaut sind. Allerdings benötigen Gehäuse für optische Systeme, die einen großen Winkelbereich erfassen oder abtasten sollen, auch immer große und ausgedehnte Fensterflächen. Die damit verbundenen großen Gehäuseformen sind jedoch für ein Waferlevel-Gehäuse unter ökonomischen Gesichtspunkten nicht annehmbar, da große Teile der verwendeten Wafer nicht für die Herstellung weiterer Bauteile genutzt werden können. Vorstellbar ist, dass eine kuppelförmige Deckelform, die eine platzsparende Konstruktion von Gehäusen mit einem großen Gesichtsfeld erlaubt, Abhilfe schaffen kann.

Ansonsten werden bislang für den Aufbau optischer Systeme auf Waferebene im Wesentlichen planparallele Anordnungen verwendet, da es an geeigneten Technologien zur 3D-Strukturierung der hermetisch dichten Gehäusestrukturen aus Glas oder Silizium mangelt, die zudem kompatibel zu dem Fügeverfahren sein müssen. Weiterhin müssen für optische Elemente Fensterflächen zur Verfügung gestellt werden, die nicht nur Reflexionen vermeiden, sondern auch große Winkelbereiche für eine einfallende und austretende Strahlung zur Verfügung stellen.

Aus US 8 151600 ist ein Verfahren zum Herstellen von Mikrokugeln aus Glas bekannt, bei dem auf einem Wafer eine Mehrzahl von Sacklöchern ausgebildet wird. Mit dem Wafer wird eine Platte aus thermisch verformbarem Glas verbunden, das die Sacklöcher abdeckt. Die Anordnung wird anschließend aufgeheizt, wodurch sich der Druck in den Sacklöchern ändert und das Glas oberhalb der Sacklöcher zu einer Kugel aufgeblasen wird.

Ein weiteres Verfahren ist aus der CN 101 734 612 A bekannt.

Der Erfindung liegt die Aufgabe zugrunde, eine MEMS Spiegelanordnung mit großem Winkelbereich für eine auf den Spiegel fallende und von diesem reflektierte Strahlung zu schaffen und ein Verfahren zum Herstellen einer MEMS Spiegelanordnung mit großem Winkelbereich für ein- und ausfallende Strahlung, zur Verfügung zu stellen, das relativ einfach zu realisieren ist, so dass die MEMS Spiegelanordnung kostengünstig herzustellen ist.

Diese Aufgabe wird erfindungsgemäß durch die Merkmale des unabhängigen Vorrichtungsanspruchs und der Verfahrensansprüche gelöst.

Durch die in den Unteransprüchen angegebenen Maßnahmen sind vorteilhafte Weiterbildungen und Verbesserungen möglich.

Die MEMS-Spiegelanordnung zum Erfassen eines großen Winkelbereichs bis zu 180°, vorzugsweise bis 160° weist einen um mindestens eine Achse schwingenden Spiegel auf, der in einer hermetisch dichten und von dem transparenten Deckel und dem Trägersubstrat begrenzten Kammer aufgehängt ist, wobei die Mitte des Spiegels im Mittelpunkt einer den transparenten Deckel bildenden Kuppel angeordnet ist. Dabei weichen die Mittelpunkte des Spiegels und der Basisfläche der Kuppel nicht mehr als ± 20% bezogen auf den Durchmesser der Basisfläche voneinander ab. Durch diese Anordnung wird eine Uniformität für alle Winkellagen des Spiegels erreicht. Die Kuppel weist eine ellipsoide Querschnittsfläche auf, die sich über einer im Wesentlichen kreisförmigen Basisfläche erhebt, wobei minimale Abweichungen von der Kreisform auftreten können. Die Kuppel weist eine innere und eine äußere Grenzfläche auf, wobei die Grenzflächen zwei Kuppelschalen definieren. Idealerweise sollten diese Kuppelschalen denselben Mittelpunkt haben.

In der Realität kann jedoch jede dreidimensionale Struktur nur angenähert hergestellt werden, so dass die beiden Mittelpunkte der Kuppelschalen auseinanderfallen können. Für die relative Lage der beiden Mittelpunkte können Toleranzbereiche definiert werden, im vorliegenden Fall ist das als AspektVerhältnis bezeichnete Verhältnis der Höhe F zum Durchmesser D der inneren und/oder äußeren Kuppelschale zwischen 0,4 und 0,6 liegt und die Differenz der Aspektverhältnisse zwischen der inneren Kuppelschale und der äußeren Kuppelschale zwischen ±0,002 liegt. Für die Verschiebung des Basisflächen-Mittelpunkts der inneren und äußeren Kuppelschale der Kuppel in vertikaler und horizontaler Richtung wird der Bereich von ±10%, vorteilhafterweise besser als ±2% angegeben.

Eine ideale sphärische Kuppel kann mit dem gewünschten Verfahren des Glasfließens oder Aufblasens nicht erzeugt werden, vielmehr ist die Form der Kuppel immer elliptisch, d.h. mindestens eine der beiden Grenzflächen besitzt keine sphärische Oberfläche und lässt sich nur durch ein Ellipsoid beschreiben. Dabei ist die Basisfläche des Ellipsoids im Wesentlichen eine Kreisscheibe. Die Kuppel ist um eine durch den Mittelpunkt der Basisfläche senkrecht dazu ausgerichtete Achse idealerweise rotationssymmetrisch. Daher besitzt mindestens eine der senkrecht zur Basisfläche orientierten Querschnittsflächen der inneren oder äußeren Kuppelschale eine elliptische Form. Eine solche elliptische Kuppel hat keine perfekten Abbildungseigenschaften mehr. Durch die elliptische Form wird der Laserstrahl zusätzlich verzerrt, d.h. die Wellenfront deformiert. Dabei sind zwei Fehlertypen besonders relevant; zum einen die Änderung der Brennweite über den Winkelbereich des Spiegels hinweg (Änderung der Fokuslage Z3 in der Wyant Zernicke Notation der Terme der Zernicke Polynomial Entwicklung), und der Astigmatismus (Zernicke Koeffizent Z4 und/oder Z5 entsprechend der Wyant Zernicke Notation der Terme der Zernicke Polynomial Entwicklung) der bedingt durch unterschiedliche lokalen Krümmungen der Oberfläche den Laserstrahl unterschiedlich stark bricht. Dabei ändert sich sowohl die Brennweite als auch der Astigmatismus kontinuierlich mit den Winkelauslenkungen des Spiegels. Vor allem der Astigmatismus verschlechtert die optischen Abbildungseigenschaften und hat besondere Bedeutung für das Auflösungsvermögen des Spiegelscanners oder - projektors und damit für die Gestaltung der Kuppel.

Mit der erfindungsgemäßen MEMS Spiegelanordnung werden die Fehler in den Abbildungseigenschaften minimiert und es wird ein ausreichend gutes Auflösungsvermögen eines Scanners mit der Spiegelanordnung über dessen gesamten Arbeitsbereich hinweg erreicht, wobei der erreichbare Fokus kleiner als 20 cm Durchmesser in 120 m Entfernung ist, was einer maximal zulässigen Divergenz des Laserstrahls von kleiner als 0,1° entspricht. Um diesen Anforderungen zu genügen, muss die mittlere Deformation der Wellenfront (RMS) des Laserstrahls kleiner als 0,5 * Wellenlänge sein (bei einer Laserwellenlänge von 905 nm), insbesondere muss die Größe des primären Astigmatismus (Z4 und /oder Z5) kleiner als 0,4 * Wellenlänge sein.

Unter Berücksichtigung dieser Anforderungen, muss die ellipsoide Kuppel dazu bestimmten geometrischen Kriterien genügen, so dass die optischen Verzerrungen, die durch den Astigmatismus der ellipsoiden Kuppel unvermeidlichen hervorgerufen werden, noch eine ausreichend gute optische Abbildung über den gesamten Winkelbereich des Spiegels zulässt. Kritisch ist in diesem Zusammenhang die Größe des Aspektverhältnisses der beiden Kuppelschalen und die Differenz der Aspektverhältnisse zwischen der inneren und äußeren Kuppelschale. Als Aspektverhältnis wird in diesem Zusammenhang das Verhältnis der vertikalen Halbachse der Ellipse zur doppelten Halbachse der Ellipse parallel zur Basisfläche des vertikalen Querschnitts durch den Ellipsoid der jeweiligen Kuppelschale verstanden. Um den oben genannten optischen Anforderungen zu genügen, sollte, wie schon oben angegeben, das Aspektverhältnis der inneren und/oder äußeren Kuppelschale zwischen 0,4 und 0,6 liegen und die Differenz der Aspektverhältnisse zwischen der inneren Kuppelschale und der äußeren Kuppelschale sollte einen Wertebereich von ±0,002 nicht überschreiten. Da bei einem größeren Spiegel innerhalb der Kuppel ein immer größerer Teil durch den Laserstrahl ausgeleuchtet wird, nimmt auch die Größe des Astigmatismus mit dem Verhältnis zwischen Spiegelgröße zu Kuppelgröße zu. Daher sollte der Spiegel eine Größe von 80% des Durchmessers der Basis der Kuppel nicht überschreiten. Noch vorteilhafter ist es, wenn der Spiegeldurchmesser eine Größe von 60% des Durchmessers der Kuppelbasis nicht überschreitet. Ist der Spiegel grösser als 80% und insbesondere grösser als 60% des Kuppeldurchmessers wird der durch den Astigmatismus der ellipsoiden Form hervorgerufene Abbildungsfehler zu groß und führt zu großen Divergenzen des Laserstrahls.

Der Durchmesser des Spiegels kann daher zwischen 5% und 80% des Durchmessers der Basisfläche der Kuppel liegen Er kann zwischen 0,2 mm und 30 mm, vorzugsweise zwischen 1 mm und 30 mm gewählt werden.

Auch bei idealen geometrischen Verhältnissen bewirkt eine ideale sphärische Kuppel eine konstante Strahldivergenz über den gesamten Winkelbereich des Spiegels hinweg. Dies gilt grundsätzlich auch für die elliptische Kuppel mit mindestens einer ellipsoiden Oberfläche, wenn auch nur angenähert. Außerdem treten neben der winkelkonstanten Brechung winkelabhängige veränderliche Komponenten hinzu, wie die bereits erwähnte Änderung der Fokuslage (Z3), und weitere Abbildungsfehler, wie der erwähnte Astigmatismus (Z4, Z5).

Während für einen Strahl des auf den Spiegel einfallenden Strahlenbündels, der genau von der Mitte des Spiegels, d.h. von der Kuppelmitte nach außen durchläuft und damit senkrecht auf die gekrümmte Oberfläche der halbschaligen sphärischen oder ellipsoidalen Kuppel trifft, keine Ablenkung des Strahls auftritt, erfahren achsenparallele Strahlen, die parallel zu den zentralen Strahlen verlaufen, eine Ablenkung. Grund dafür ist eine Brechung, die diese Strahlen bei Eintritt in das höher brechende Medium der Kuppel erfahren und die dazu führt, dass die Stelle, an der der Strahl in die Kuppel eintritt, lokal eine andere Neigung aufweist, als die Stelle, an der der Strahl wieder austritt. Die Größe der dadurch hervorgerufenen Strahlablenkung wird dabei direkt von dem lokalen Neigungswinkel, unter dem der Strahl auf die Kuppel trifft, und der Größe des durch die Brechung hervorgerufenen Strahlversatzes bestimmt.

Während der lokale Neigungswinkel von dem Durchmesser des gesamten Strahlenbündels und der Größe der Kuppel bestimmt wird, hängt die Größe des Strahlversatzes von der Brechzahl des Materials der Kuppel sowie von deren Dicke ab.

Die Brennweite einer idealen sphärischen Kuppel mit konstanter Wanddicke ergibt sich zu:

$$f = -\frac{n}{2(n-1)} \cdot \frac{R(R-d)}{d}$$

wobei n der Brechungsindex, d die Wandstärke der Kuppel und R der Radius der Kuppel sind.

Da letztlich alle fertigungsbedingten weiteren Abweichungen der Kuppelform von der angestrebten Form, ob sphärisch oder elliptisch, die zu einer Änderung der optischen Eigenschaften bzw. der Brechkraft der Kuppel führen, mit dem Kehrwert oder gar mit dem quadratischen Kehrwert der Brennweite skalieren, sollte eine möglichst große Brennweite angestrebt werden, was sich bei vorgegebenem maximalen Radius der Kuppel nur durch eine möglichst geringe Wandstärke erreichen lässt. Allerdings kann die Wandstärke nicht beliebig reduziert werden, da beispielsweise die Kuppel auch in der Lage sein muss, einen Differenzdruck von mindestens 1 bar dauerhaft zu widerstehen, wenn im Inneren der Kuppel ein Vakuum herrscht. Eine halbschalige sphärische oder ellipsoidale Form der Kuppel ist in ganz besonderem Maße geeignet, Druckkräfte aufzunehmen und in das Trägersubstrat abzuleiten. Es hat sich gezeigt, dass ein Verhältnis des Quadrats des Radius R der Kuppel zu der Dicke d der Wand der Kuppel größer als 50, d.h. $R^2/d>50$, auch hinsichtlich der Toleranzen des Herstellungsverfahrens vorteilhaft ist.

Die durch die Kuppel auftretende Strahldivergenz, gegebenenfalls auch eine Strahlkonvergenz, muss kompensiert werden, um den hohen Anforderungen an die Auflösung z.B. eines LIDAR-Systems oder eines Projektors, für die die erfindungsgemäße MEMS Spiegelanordnung eingesetzt wird, gerecht werden zu können. Die dafür vorgesehene Kompensationsoptik kollimiert den Laserstrahl vor der Kuppel derart, dass nach dem Durchlaufen der Kuppel und der Reflexion durch den Spiegel wieder ein im Wesentlichen paralleler Laserstrahl vorliegt.

Erfindungsgemäß ist die Kompensationsoptik als eine oder mehrere Linsen und/oder als ein oder mehrere Hohlspiegel ausgebildet. Besonders leistungsfähig ist eine Optik, die konvexe und konkave optische Oberflächen einsetzt, vorzugsweise eine oder mehrere konkav-konvexe Linsen.

Die Kuppel kann aus Glas, einschließlich Quarzglas und/oder Siliziumdioxid bestehen, aber vorzugsweise auch aus einem Material, das einen an Silizium angepassten thermischen Ausdehnungskoeffizienten besitzt.

Die Kompensationsoptik sollte derart ausgebildet sein, dass der kleinste Strahldurchmesser der einfallenden Strahlung auf dem Spiegel liegt, d.h., die Optik darf keine zusätzliche Strahleinschnürung des Laserstrahls, besonders keine, die vor dem Spiegel liegt, bewirken. Anderenfalls wird die Größe der Beugung, die zu einer zusätzlichen Strahldivergenz führt, durch die minimale Taillierung des Laserstrahls bestimmt und nicht durch den Mikrospiegel.

Die Brennweite der Kompensationsoptik ergibt sich zu:

$$f_{komp} = -f_{kuppel} + a$$

wobei a der Abstand zwischen der bildseitigen Hauptebene der Kuppel und der objektseitigen Hauptebene der Kompensationsoptik ist.

In dem Ausführungsbeispiel der vorliegenden Erfindung kann die Brennweite der Kuppel näherungsweise und mit umgekehrten Vorzeichen der Brennweite der Kompensationsoptik entsprechen. Dies ist eine gewisse Näherung, da, wie aus der Formel zu entnehmen ist, der Abstand a zwischen den beiden optischen Hauptebenen der Kuppel und der Kompensationsoptik auch mit eingeht. Der Abstand Kompensationsoptik-Spiegel ist jedoch klein gegenüber der Brennweite der Kuppel, so dass die Näherung zulässig ist.

In einem bevorzugten Ausführungsbeispiel kann die Brennweite der Kuppel zwischen 50 mm und 300 mm liegen.

Das Verfahren zur Herstellung einer MEMS Spiegelanordnung entsprechend den obigen Ausführungen, bei der ein transparenter Deckel mit einem Trägersubstrat, an dem ein um mindestens eine Achse schwingender Spiegel aufgehängt ist, hermetisch dicht verschlossen wird, folgende Schritte auf: Bereitstellen eines Siliziumwafers, Strukturieren des Siliziumwafers derart, dass eine Mehrzahl von Vertiefungen hergestellt werden, die jeweils der Grundfläche des Deckels entsprechen, Aufbonden eines Deckelwafers aus glasartigem Material auf den strukturierten Siliziumwafer, wobei ein Inertgas bei einem vorgegebenen Druck in den durch die Vertiefungen und den Deckelwafer gebildeten Kavitäten eingeschlossen wird, Tempern des Verbundes aus Siliziumwafer und Deckelwafer derart, dass durch die Expansion des eingeschlossenen Inertgases eine Mehrzahl von Kuppeln gebildet wird, nach Abkühlen des Verbundes aus Siliziumwafer und Deckelwafer teilweises oder vollständiges Entfernen des Siliziumwafers, Anordnen eines Spiegelwafers, der eine Mehrzahl von am Trägersubstrat aufgehängten Spiegeln umfasst, zu dem Deckelwafer derart, dass die Spiegelmitten jeweils im Mittelpunkt der Kuppeln liegen, Fügen und hermetisch dichtes Verschließen des Deckelwafers mit dem Spiegelwafer durch Bonden mit additiv aufgebrachten Schichten oder Strukturen, Vereinzeln des Verbundes aus Deckelwafer und Spiegelwafer in einzelne verkappte MEMS Spiegelanordnungen.

In einer anderen Ausführungsform des erfindungsgemäßen Verfahrens wird anstelle des Siliziumwafers ein Werkzeug verwendet, das aus einem ein Ankleben eines heißen glasartigen Materials verhindernden Material besteht oder das mit einem ein Ankleben eines heißen glasartigen Materials verhindernden Material beschichtet ist. Dieses Werkzeug ist oder wird mit Durchgangsöffnungen versehen. Ein Deckelwafer aus glasartigem Material wird auf das mit Durchgangsöffnungen versehenes Werkzeug aufgelegt und es wird ein Unterdruck auf der vom Deckelwafer abgewandten Seite angelegt. Das Tempern des Verbundes aus Werkzeug und Deckelwafer erfolgt bei atmosphärischen Bedingungen derart, dass durch Ansaugen des Deckelwafers in die Durchgangsöffnungen aufgrund des Unterdrucks eine Mehrzahl von Kuppeln gebildet wird. Nach Abkühlen des Verbundes aus Werkzeug und Deckelwafer wird das Werkzeug entfernt. Die weiteren Schritte entsprechen denen des vorher angegebenen Verfahrens.

Die Spiegelanordnung gemäß der Erfindung zum Erfassen eines großen Winkelbereichs, die mittels den Ausführungsformen der beschriebenen Verfahren herstellbar ist, umfasst wie oben ausgeführt ein Trägersubstrat, das Bestandteil des beim Verfahren beschriebenen Spiegelsubstrats bzw. Spiegelwafers ist und an dem ein um mindestens eine Achse schwingender Spiegel aufgehängt ist, einen transparenten Deckel, der mit dem Trägersubstrat hermetisch dicht verbunden ist und eine Kuppel mit sich daran anschließenden ebenen Bereichen aufweist, und eine Kompensationsoptik, die in einem vorgegebenen Strahlengang für ein einfallendes Strahlenbündel außerhalb der Kuppel angeordnet ist, wobei die Mitte des Spiegels im Mittelpunkt der Kuppel liegt, und wobei die Kompensationsoptik das einfallende Strahlenbündel derart kollimiert, dass eine durch die Grenzflächen der Kuppel hervorgerufene Divergenz oder Konvergenz des Strahlenbündels nach dem Austritt aus der Kuppel zumindest teilweise kompensiert ist.

Durch die erfindungsgemäßen Verfahren kann eine erfindungsgemäße Deckelform für die MEMS Spiegelanordnung hergestellt werden, die ein großes Sichtfeld, gegebenenfalls bis zu 180° erlaubt, ohne dass die Chipfläche bzw. das Trägersubstrat unnötig groß werden muss. Das Trägersubstrat bzw. die Chipfläche der MEMS Spiegelanordnung wird somit nicht von der Notwendigkeit der Optik bestimmt. Die erfindungsgemäßen Verfahren ermöglichen darüberhinaus eine kostengünstige Herstellung einer Vielzahl von MEMS-Spiegelanordnungen.

Die Herstellung erfolgt mittels Glasfließen. Hierzu wird beim anodischen Aufbonden des Glaswafers auf den strukturierten Siliziumwafer ein Druck von 100 mbar bis 3 bar, vorzugsweise 1 bar bis 1,2 bar eines Inertgases, typischerweise Stickstoff, in den Kavitäten eingeschlossen.

Besonders vorteilhaft ist die Temperung unter Vakuum, wodurch recht hohe Kuppeln hergestellt werden können, ohne sehr tiefe Siliziumkavitäten oder hohe Gasdrücke in den Kavitäten zu benötigen. Während des Abkühlens nach dem Tempern sollte keine Kraft mehr auf die Kuppel ausgeübt werden. Falls die eigentliche Temperung nicht in einem Vakuum erfolgte, ist es vorteilhaft, den Gasdruck innerhalb des Ofens mit der Temperatur entsprechend der idealen Gasgleichung nachzuführen, um so ein erneutes Fließen des Glases der Kuppel und damit einhergehend eine Formänderung während des Abkühlens zu vermeiden.

Gemäß der Erfindung wird das Tempern unter Vakuum bei 650°C - 950°C, vorzugsweise bei 700°C - 800°C, noch bevorzugter bei 710°C durchgeführt, wobei es nach einer definierten Zeit von 30 Minuten bis 12 Stunden, vorzugsweise nach etwa 2 Stunden beendet und unter Vakuum abgekühlt wird. Grundsätzlich soll die Temperung so erfolgen, dass sich die Form langsam der gewünschten endgültigen Kuppelform annähert. Eine geringe Fließgeschwindigkeit gegen Ende des Temperprozesses führt aufgrund der Wirkung der Oberflächenspannung zu besonders guten, nahezu sphärischen Oberflächenformen. Dabei werden die Parameter Tiefe der Vertiefungen des strukturierten Siliziumwafers, Druck des in den Kavitäten eingeschlossenen Gases, Temperatur des Temperns und Zeit des Temperns so gesteuert, dass die Fließgeschwindigkeit des glasartigen Materials gegen Ende des Temperns, vorzugsweise bei den letzten 20% der Temperzeit, kleiner als 0,5 mm pro Stunde ist. Auf diese Weise wird die gewünschte Kuppelform im Wesentlichen erreicht.

Bei dem Verfahren mit der Verwendung eines Werkzeugs mit Durchgangsöffnungen werden die Parameter Differenzdruck zwischen dem atmosphärischen Druck und dem Unterdruck auf der zu dem Deckelwafer entgegengesetzten Seite des Werkzeugs, Temperatur des Temperns und Zeit des Temperns so gesteuert bzw. der Differenzdruck so nachgeführt, dass die Fließgeschwindigkeit des glasartigen Materials gegen Ende des Temperns, vorzugsweise bei den letzten 20% der Temperzeit, kleiner als 0,5 mm pro Stunde ist. Auch auf diese Weise wird die gewünschte Kuppelform im Wesentlichen erreicht.

Nach Abschluss des eigentlichen Glasformungsprozesses wird das Silizium teilweise oder vollständig entfernt, wobei dies mechanisch erfolgen kann oder auch aufgrund der sehr hohen Topografie der Kuppeln auf nasschemischem Wege, z.B. mit heißer Kalilauge, durch Wegätzen ausgeführt werden kann.

Durch die mechanische Dehnung des Glases beim Glasfließen beträgt die Wanddicke der Kuppel ca. 50% des ursprünglichen Glassubstrats. Dennoch werden für die Herstellung sehr dünnwandiger Glaskuppeln mit einer Wanddicke

beispielsweise von 1 μm bis 0,5 mm auch entsprechend dünne Glassubstrate mit Dicken im Bereich von 200 μm oder sogar noch weniger benötigt. Solch dünne Glassubstrate lassen sich normalerweise aufgrund der damit verbundenen Bruchgefahr nicht mehr zuverlässig handhaben. Es hat sich aber gezeigt, dass im Falle der verwendeten Glasdeckelwafer durch das Einbringen der sehr hohen Kuppelstrukturen dieser Glaswafer bzw. Deckelwafer stark an mechanischer Steifigkeit und Stabilität gewinnt. Da jedoch die Kuppeln in einem festen Raster über dem jeweiligen Wafer hinweg angeordnet sein müssen, um das abschließende Sägen in einzelne Chips oder Bauteile gewährleisten zu können, entstehen Achsen innerhalb des Deckelwafers, die nicht von der mechanischen Versteifung durch die Kuppeln profitieren. Hier könnten zusätzliche lange zylindrische Strukturen, die zwischen den Kuppeln ausgebildet werden, und umlaufende domartige Strukturen im Randbereich des Wafers für die erforderliche zusätzliche Stabilität und Steifigkeit sorgen.

Für die meisten optischen Anwendungen müssen die eingesetzten Komponenten entspiegelt werden. Dazu wird nach dem Tempern und Entfernen des Siliziumwafers bzw. des Werkzeugs in der Regel eine Abfolge dünner ($\lambda/4$) Schichten auf die optische Oberfläche der Kuppeln aufgebracht. Es können CVD-Verfahren, d.h. chemische Abscheidung aus der Gasphase, eingesetzt werden, das sogenannte ALD (Atomic Layer Deposition) erscheint hier besonders geeignet, da eine hohe Formtreue gegeben ist und die Schichtdicke der Beschichtung nicht über die Kuppel variiert.

Das Fügen und hermetisch dichtes Verschließen des Deckelwafers und des Spiegelwafers kann durch Aufbringen eines Versiegelungsmaterials umlaufend um jede Kuppelstruktur auf den Deckelwafer und/oder auf den Spiegelwafer und durch anschließendes sogenanntes additives Bonden realisiert werden, bei dem additiv aufgebrachte Schichten oder Strukturen verwendet werden.

Additive Waferfügeverfahren (= Waferbonden) nutzen zusätzliche, auf die Substrate aufgebrachte Strukturen aus Metallen oder Glas um Silizium oder Glassubstrate fügen zu können. Im Folgenden sind hier im speziellen immer Rahmenstrukturen gemeint, die die eigentlichen nutzbaren MEMS Strukturen einfassen.

Beim eigentlichen Bonden werden die MEMS Strukturen dann hermetisch dicht verschlossen d.h. dauerhaft gegenüber dem Eindringen von Gasen oder Feuchtigkeit verschlossen. Insbesondere bleibt dadurch ein Unterdruck oder Vakuum in den so verschlossenen Volumina über Jahre und Jahrzehnte erhalten.

Beispiele für das Waferbonden mit additiven Verfahren sind das sogenannte Glasfritt-Bonden bei dem auf einem der Fügepartner mittels Siebdrucken eine Paste aus einem sehr niedrige schmelzenden Glas aufgedruckt und anschließend zu einem geschlossenen Rahmen umgeschmolzen wird. Das anschließende Bonden der Wafer erfolgt dann typischerweise bei Temperaturen von 420°C-450°C. Dabei werden die Wafer zusammen gepresst um einen sicheren Kontakt über die gesamte Waferfläche zu erreichen.

Ein anderes sehr wichtiges Verfahren ist das sogenannte eutektische Bonden mit metallischen Legierungen. Im Endeffekt handelt es sich um ein Löten der beiden Fügepartner bei dem zuvor die Metalle auf mindestens einem der Wafer /Substrate abgeschieden und anschließend strukturierter wurden. Dabei kann entweder die eigentliche Legierung des Lots auf einem der beiden Wafer aufgebracht werden (z.B. Gold-Zinn Lot) oder aber die Legierung liegt in Form voneinander getrennter Schichten vor, und bildet erst beim Bonden die eigentliche Legierung aus, die dabei auch zumindest in der Kontaktzone der beiden Wafer aufschmilzt. Die verschiedenen einzelnen Schichten der Komponenten der Legierung des Lots können dabei entweder auf einem der beiden Wafer angeordnet oder aber auf beide Wafer verteilt aufgebracht werden.

So kann zum Beispiel das Löten mit Gold-Zinn auch dadurch erfolgen, dass auf einem der beiden Wafer das benötiget Zinn und auf dem anderen das Gold aufgebracht wird und erst beim Kontakt und Erhitzen der beiden Wafer mit einander reagiert und eine schmelzflüssige Phase ausbildet.

In der Praxis findet dieses Vorgehen allerdings nur bei dem Gold-Silizium Bonden Anwendung, wobei das flüssige Gold-Silizium Eutektikum bei Temperaturen oberhalb von 363°C entsteht, wenn das Gold des Bondrahmens auf dem einen Wafer mit dem Silizium des anderen Wafers in Kontakt gebracht wird.

In allen diesen Fällen wird das Material in der Fügezone während des Bondens zumindest temporär flüssig oder aber sehr weich (Glaslot) und ist damit in der Lage Unebenheiten auszugleichen. Die Festigkeit wird erst nach dem Abkühlen erreicht in dem die Lotverbindungen erstarren.

Eine spezielle Klasse von Bondverfahren sind Methoden die die plastische Verformung weicher Metalle ausnutzt. Dazu werden ebenfalls Metallische Rahmenstrukturen auf beide Fügepartner hergestellt etwa durch auch Aufdampfen und Ätzen oder durch eine Galvanische Abscheidung. Anschließend werden die beiden Wafer unter hohem Druck und Temperatur zusammengepresst, wobei die Rahmenstrukturen regelrecht zusammen gequetscht werden (=Thermokompressionsbonden).

Alle anderen Waferfügeverfahren basieren dagegen entweder auf chemischen Reaktionen während des Bondens und nutzen dabei die Substrateigenschaften aus (anodisches Bonden, Fusion Bonding).

In Fällen in denen sowohl die Fügezonen auf dem Spiegelwafer als auch des Deckelwafers sehr glatt und eben sind, können auch hermetische dichte Fügeverfahren, die ohne ein zusätzliches Versiegelungsmaterial in der Fügezonen auskommen, verwendet werden, um einen hermetisch dichten Verschluss zwischen den beiden Wafern zu erreichen. Neben dem direkten Waferbonden, das letztlich auf dem Ansprengen spiegelglatter Oberflächen beruht, kommt hierfür vor allem das anodische Bonden (engl. " anodic bonding") in Betracht, bei dem durch einen elektrochemischen Prozess die Glasoberflächen mit Silizium reagiert und hermetisch dicht gefügt wird. Dabei wird bei Temperaturen zwischen 300° C und 450°C durch Anlegen einer elektrischen Spannung von einigen 100 V zwischen dem Glas des Deckelwafers und dem Silizium eine Oxidation der Siliziumoberfläche herbeigeführt die letztlich beide Oberflächen untrennbar miteinander verschweißt.

Sind die Oberflächen des Deckel- oder Spiegelwafer nicht ausreichend eben oder glatt (< 10 nm) müssen vor der Versiegelung des Spiegelwafers mit dem Deckelwafer die eigentlichen Versiegelungsmaterialien entsprechend dem sogenannten additiven Bonden aufgebracht werden. In einem Ausführungsbeispiel wird als Versiegelungsmaterial ein aufdruckbares Versiegelungsmaterial, vorzugsweise ein schmelzfähiges Lot verwendet. Dieses Aufdrucken der Fügeschicht oder zumindest deren Strukturierung ist aus ökonomischer und technischer Sicht auch unter Berücksichtigung der hohen Topografie des Deckelwafers besonders bevorzugt. Allen voran sei hier das Aufdrucken von niederschmelzenden Glasloten genannt, da hierbei nur einer der beiden Fügepartner mit dem als Glaspaste ausgebildeten Glaslot bedruckt werden muss, was in der Regel aufgrund prozesstechnischer Vorteile der Deckelwafer ist.

In vorteilhafter Weise wird das Versiegelungsmaterial an Fügezonen zwischen Deckelwafer und Spiegelwafer aufgebracht, wobei in einem Ausführungsbeispiel die Fügezonen zur Ableitung der Druckkräfte beim Bonden direkt unterhalb der Wandungen der Kuppeln liegen. Die sphärische Form der Oberfläche ist sehr gut geeignet, einwirkende Druckkräfte aufzunehmen und in den Spiegelwafer abzuleiten. Daher können die Fügezonen der beiden Wafer den Bereich direkt unterhalb der Kuppeln umfassen. Bei einem Versatz der Fügezonen könnten anderenfalls erhebliche mechanische Spannungen gerade in der Übergangszone zwischen den Wänden der Kuppel und ebenem Bereich der Deckelwafer auftreten.

Vorteilhaft ist, dass beim Fügen bzw. Bonden des Deckelwafers und des Spiegetwafers die benötigten Druckkräfte punktuell oder linienförmig aufgebracht werden. Aufgrund der hohen Topografie des Deckelwafers muss der abschließende Bondvorgang gegenüber dem etablierten Verfahren modifiziert werden. Da während des Bondens die Wafer in der Regel aufeinander gepresst werden müssen, die optischen Oberflächen aber möglichst nicht mechanisch belastet werden sollten, um Beschädigungen zu vermeiden, wird der mechanische Druck nur punktuell und nicht ganzflächig aufgebracht. Beispielsweise kann mit Hilfe von Werkzeugen der Druck auf bis zu 25 über den Wafer hinweg verteilten Stellen aufgebracht werden. Die mechanische Steifigkeit des Wafers verteilt den eingeleiteten Druck hinreichend über den gesamten Wafer hinweg, so dass alle Gehäuse, bestehend aus den die Kuppeln umfassenden Deckeln und dem Trägersubstrat, auf dem Wafer hermetisch dicht verschlossen werden können.

Eine andere Möglichkeit des Bodens des Deckelwafers und des Spiegelwafers liegt darin, dass sie an ihren Randbereichen dicht miteinander verbunden werden und dass anschließend das Bonden pneumatisch durchgeführt wird. Somit können der oder die Wafer erst am Waferrand ringförmig verbunden werden, so dass der Waferstapel vakuumdicht abgeschlossen ist, und die eigentliche Bondung kann dann rein pneumatisch erfolgen. Dazu wird der Wafer entweder noch im Bonder oder in einem nachgelagerten Ofenschritt unter Atmosphärendruck erhitzt, wodurch das Fügematerial erneut erweicht und die beiden Wafer durch den auflastenden pneumatischen Druck aufeinander gepresst werden.

Als Spiegelwafer wird sowohl der Wafer bezeichnet, der die Trägerstruktur bzw. das Trägersubstrat für die einzelnen Spiegel bildet als auch ein rückwärtiger Wafer, der mit dem Wafer der Trägerstruktur verbunden ist. Dabei kann das Verbinden in einem vom Bonden getrennten Schritt oder auch zusammen mit dem Bonden des Deckelwafers durchgeführt werden.

Ausführungsbeispiele der Erfindung sind in der Zeichnung dargestellt und werden in der nachfolgenden Beschreibung näher erläutert. Es zeigen

Fig. 1      einen Schnitt durch die erfindungsgemäße Spiegelanordnung nach einem ersten Ausführungsbeispiel, wobei die Kompensationsoptik weggelassen ist,

Fig. 2      eine Darstellung entsprechend Fig. 1 mit Kompensationsoptik und Strahlengang,

Fig. 3      einen Verfahrensablauf gemäß den Schritten a) bis g) für die Herstellung der erfindungsgemäßen Spiegelanordnung nach einem ersten Ausführungsbeispiel,

Fig. 4      einen Verfahrensablauf gemäß den Schritten a) bis e) für die Herstellung der erfindungsgemäßen Spiegelanordnung nach einem weiteren Ausführungsbeispiel, und

Fign. 5a) und 5b)      eine Aufsicht und einen Schnitt auf einen Wafer mit einer Vielzahl von Spiegelanordnungen.

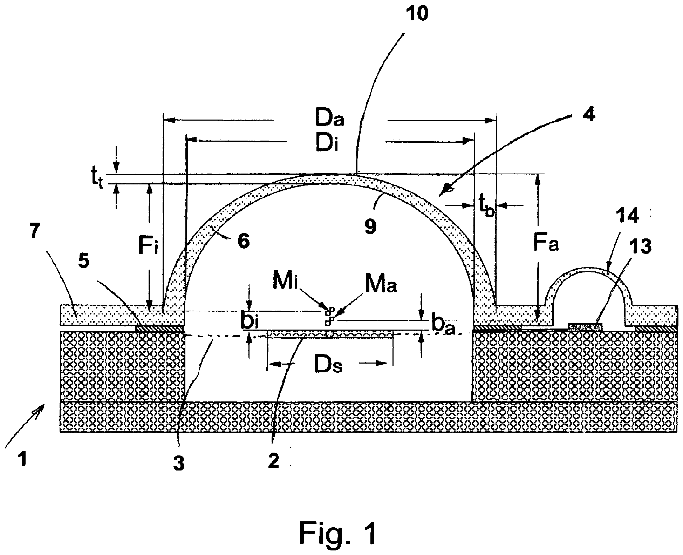

Die in Fig. 1 dargestellte Teil einer Spiegelanordnung weist ein Trägersubstrat 1 auf, an dem in bekannter Weise ein Spiegel 2 über gestrichelt dargestellte Federn 3, die beispielsweise als Torsionsfedern ausgebildet sein können, einachsig oder zweiachsig aufgehängt ist. Der Spiegel 2 wird über einen nicht dargestellten Antrieb zur Drehung bzw. zum Schwenken um den Spiegelmittelpunkt herum angetrieben. Das Trägersubstrat 1 kann aus mehreren Substratschichten, im vorliegenden Ausführungsbeispiel aus zwei Substratschichten, bestehen, gegebenenfalls kann es auch in einem Teil ausgebildet sein.

Mit dem Trägersubstrat 1 ist ein Gehäusedeckel 4 hermetisch dicht über Fügezonen 5 verbunden, wobei der Gehäusedeckel 4 eine angestrebte halbschalige sphärische oder ellipsoide Kuppel 6 aus einem für eine gewünschte einfallende und austretende Strahlung durchlassendes Material aufweist. Beispielsweise kann die Kuppel 6 aus einem Glasmaterial bestehen, wobei das Glas für sichtbare Strahlung durchlässig ist. Idealerweise sollte das Material der Kuppel einen thermischen Ausdehnungskoeffizienten aufweisen, der an Silizium angepasst ist, um thermomechanische Spannungen nach dem temperaturbehafteten Fügeprozess zu vermeiden. An die Kuppel 6 schließen sich ebene Bereiche 7 an und die Fügezonen 5 sind so positioniert, dass sie unterhalb der Kuppelwand an den Übergangsstellen der Kuppel 6 zu den ebenen Bereichen 7 vorgesehen sind.

Wie ausgeführt wird eine ideale halbkugelförmige Kuppel 4 angestrebt, die jedoch mit dem verwendeten später beschriebenen Herstellungsverfahren nicht erreichbar ist. Daher hat die Kuppel 4 eine elliptische Form mit einer kreisförmigen Basis- oder Grundfläche. Dabei ist mindestens eine der Grenzflächen, die als innere 9 und äußere Kuppelschale 10 bezeichnet werden, elliptisch, meist sind es beide Grenzflächen, wodurch Abbildungsfehler entstehen, vor allem Astigmatismen, wobei die Größe des Astigmatismus maßgeblich bestimmt, wie gut sich der Laserstrahl überhaupt noch fokussieren lässt. Die Größe des Fokus bestimmt aber das erreichbare Auflösungsvermögen (Zahl der Bildpunkte) des die Spiegelanordnung verwendenden Scanners oder Projektors. Dafür muss die Kuppelform innerhalb eines bestimmten charakteristischen geometrischen Parameterbereichs liegen. Zur Bestimmung dieses bzw. der Parameterbereiche sind in Fig. 1 Definitionen für die Abmessungen angegeben.

$F_i$ ist die vertikale Halbachse der inneren elliptischen Kuppelschale bzw. der vertikale Abstand zwischen dem Mittelpunkt der Ellipse und dem Kuppelinneren. $F_a$ ist die vertikale Halbachse der äußeren Ellipse bzw. der vertikale Abstand zwischen dem Mittelpunkt dieser Ellipse und dem Kuppeläußeren.

$D_i$ ist der innere Durchmesser der Kuppel bzw. die große Achse der Querschnitts-Ellipse. $D_a$ ist der äußere Durchmesser der Kuppel bzw. die große Achse der Querschnitts-Ellipse. $t_t$ ist die Dicke der Kuppelschale am Scheitelpunkt. $t_b$ ist die Dicke der Kuppelschale an der Basis.

$M_i$ ist der Mittelpunkt des elliptischen Kuppelquerschnitts der inneren Kuppelschale. $M_a$ ist der Mittelpunkt des elliptischen Kuppelquerschnitt der äußeren Kuppelschale. $b_i$ ist der Abstand zwischen Mittelpunkt elliptischen innere Kuppelschale und der Spiegeloberfläche. $b_a$ ist der Abstand zwischen Mittelpunkt elliptischen äußeren Kuppelschale und der Spiegeloberfläche.

$D_s$ ist der Durchmesser des Spiegels.

Das sogenannte Aspektverhältnis $F_{i(a)}/D_{i(a)}$ jeweils der inneren 9 und äußeren 10 Kuppelschale liegt zwischen $0,4 < F_i/D_i$ bzw. $F_a/D_a < 0,6$ und die Differenz der Aspektverhältnisse $F_a/D_a - F_i/D_i$ muss zwischen $0,002 < F_a/D_a - F_i/D_i < 0,002$ liegen. Die maximale Dicke der Kuppel 6 soll dabei an jeder Stelle kleiner als 10% des Durchmessers der Kuppel 6 sein, im vorliegenden Fall des Durchmessers Di der Grundfläche. Diese charakteristischen Größen gelten solange der Spiegeldurchmesser im Verhältnis zum Kuppeldurchmesser nicht zu groß ist, d.h. der Spiegeldurchmesser $D_s$ soll in einem Bereich von $0,05 < D_s < 0,8$ in Relation zum Durchmesser Di der Grundfläche der Kuppel 6 liegen.

Der Spiegel 2 soll so positioniert sein, dass der Mittelpunkt des Spiegels in der Mitte der runden Grundfläche der Kuppel 6 liegt. Dabei sollten die Mittelpunkte $M_i$, $M_a$ nicht mehr als $\pm 20\%$ bezogen auf den Durchmesser Di der Grundfläche voneinander abweichen. Auch sollen die Mittelpunkte $M_i$, $M_a$ der elliptischen Querschnittsflächen der inneren 9 und äußeren 10 Kuppelschalen nicht mehr als $\pm 20\%$ vom Mittelpunkt des Spiegels in vertikaler Richtung, immer bezogen auf die Grund- oder Basisfläche der Kuppel 6, abweichen.

In Fig. 1 ist mit 13 ein elektrischer Anschlusspad 13 für die Ansteuerung des Spiegels 2 dargestellt. Über dem Anschlusspad ist eine zylindrische Kuppel 14 aus Glas ausgebildet, die Bestandteil des Glaswafers ist und die beim Vereinzeln zu den Waferchips oder den einzelnen Spiegelanordnungen durch Sägen geöffnet wird.

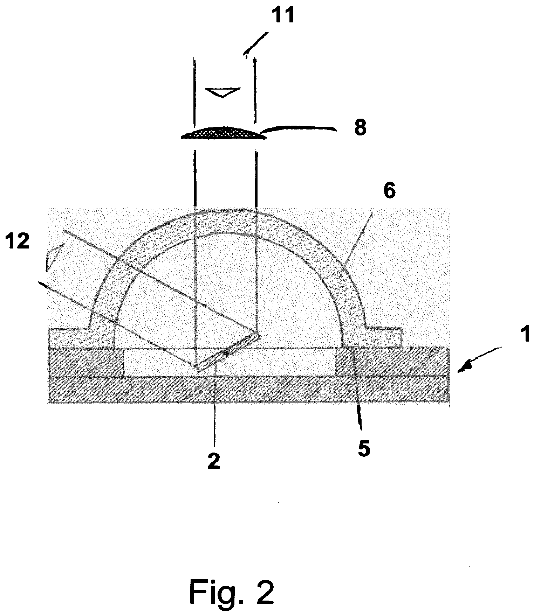

Um eine durch die Brechung an der Kuppel 6 auftretende Strahldivergenz zu kompensieren, ist gemäß Fig. 2 eine Kompensationsoptik 8 vor der Kuppel 6 angeordnet, die im vorliegenden Fall als konvexe Linse ausgebildet. In der Fig. 2 ist der Strahlengang 11, 12 nur schematisch dargestellt und zeigt nicht den vom parallelen Strahlengang abweichenden Verlauf. Die Kompensationsoptik 8 kollimiert das einfallende Strahlenbündel 11 derart, dass der kleinste Strahldurchmesser der einfallenden Strahlung auf dem Spiegel 2 liegt und dass eine durch die kuppelförmigen Grenzflächen, die innere Kuppelschale 9 und die äußere Kuppelschale 10 der Kuppel 6, hervorgerufene Divergenz des Strahlenbündels als Wirkung einer Zerstreuungslinse nach dem Austritt aus der Kuppel 6 im Wesentlichen kompensiert ist und als parallelisierter Strahl 12 austritt. Dazu liegt die Mitte des Spiegels 2 im Mittelpunkt der Kuppel 6. Eine solche Spiegelanordnung nach den Fign. 1 und 2 ist für Scanner, Projektoren, LIDAR-Systeme und dergleichen anwendbar.

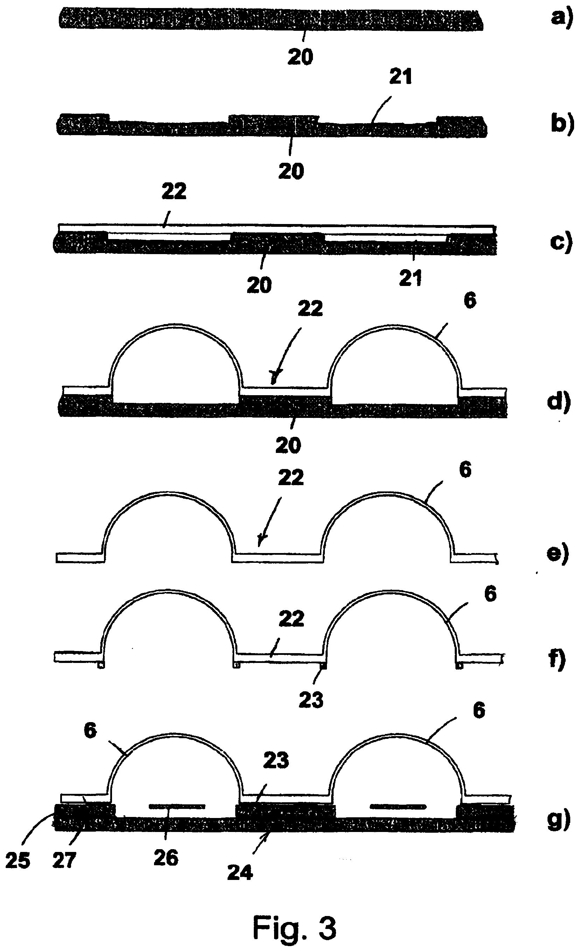

In Fig. 3a) bis 3g) sind die Herstellungsschritte für die Spiegelanordnung nach Fig. 1 dargestellt. Gemäß Fig. 3a) wird ein Siliziumwafer 20 bereitgestellt, das durch Strukturieren, vorzugsweise durch Hochratenätzen mit Vertiefungen 21 versehen wird, wobei die Vertiefungen beispielsweise eine Höhe von 200 $\mu$m aufweisen (Fig. 3b)). Auf den Siliziumwafer 20 mit den strukturierten Vertiefungen 21 wird ein Glaswafer bzw. Deckelwafer 22 aufgebondet, vorzugsweise unter einem Druck von 1,2 bar, wobei die Kavitäten, d.h. die abgeschlossenen Vertiefungen 21 mit einem inerten Gas, vorzugsweise Stickstoff $N_2$ gefüllt wird.

Diese Anordnung gemäß Fig. 3c) wird unter Vakuum in einem Temperofen, beispielsweise bei Temperaturen zwischen 700°C und 800°C getempert, wodurch das Glas bis zur Fließgeschwindigkeit erweicht, und durch die Druckänderung in den Kavitäten die Kuppel 6 gebildet wird. Während des Temperns nähert sich die Form des fließenden Glassubstrats 22 der Kuppelform an, und damit eine besonders gute sphärische Oberflächenform erzeugt wird, und zwar unter Wirkung der Oberflächenspannung, beträgt bei den letzten 20% der Temperzeit die Fließgeschwindigkeit des Glasmaterials weniger als 0,5 mm pro Stunde. Nach etwa 2 Stunden wird der Prozess beendet und die Anordnung aus verformten Glaswafern bzw. Deckelwafer 22 und Siliziumwafer 20 wird im Ofen, vorzugsweise unter Vakuum, abgekühlt und anschließend belüftet (Fig. 3d)). Nach Abschluss des Glasformungsprozesses wird das Siliziumsubstrat 20 teilweise oder vollständig, wie hier unter Fig. 3e) gezeigt, entfernt. Dies kann mechanisch durchgeführt werden oder aber auch auf nasschemischem Wege.

Die Anordnung gemäß Fig. 3e), d.h. der verformte Glaswafer 22 wird üblicherweise mit einer Antireflexbeschichtung auf beiden Seiten, d.h. sowohl auf der Innenfläche der Kuppeln 6 als auch auf der Außenfläche der Kuppeln 6 mittels ALD versehen, die eine Abfolge von dünnen $\lambda/4$-Schichten sein kann. Anschließend wird ein niedrigschmelzendes Glaslot 23 als Glaspaste aufgedruckt und zwar an den beabsichtigten Fügezonen 5 an dem Übergang der Kuppeln 6 zu den ebenen Flächen 7 des Glaswafers 22 (siehe Fig. 3f)). Die Fügezonen liegen somit direkt unter der Wandung der Kuppeln 6. Das Glaslot 23 wird getempert und verglast, und anschließend wird der mit den Kuppeln 6 versehene Glaswafer 22 als Deckelwafer mit einem vorgefertigten Spiegelwafer 24 durch Bonden verbunden, wobei der Deckelwafer und der Spiegelwafer 24 über eine aufgesetzte Hilfsstruktur aufeinander gepresst werden. Der Spiegelwafer wurde im Vorhinein präpariert und kann aus dem eigentlichen Trägersubstrat 25 für die Spiegel 26 und aus einem rückwärtigen Substrat 27 bestehen. Eine solche Anordnung ist in Fig. 3g) gezeigt. In einem letzten Schritt wird die Anordnung nach Fig. 3g) beispielsweise durch Sägen in eine Mehrzahl von MEMS Spiegelanordnungen geteilt.

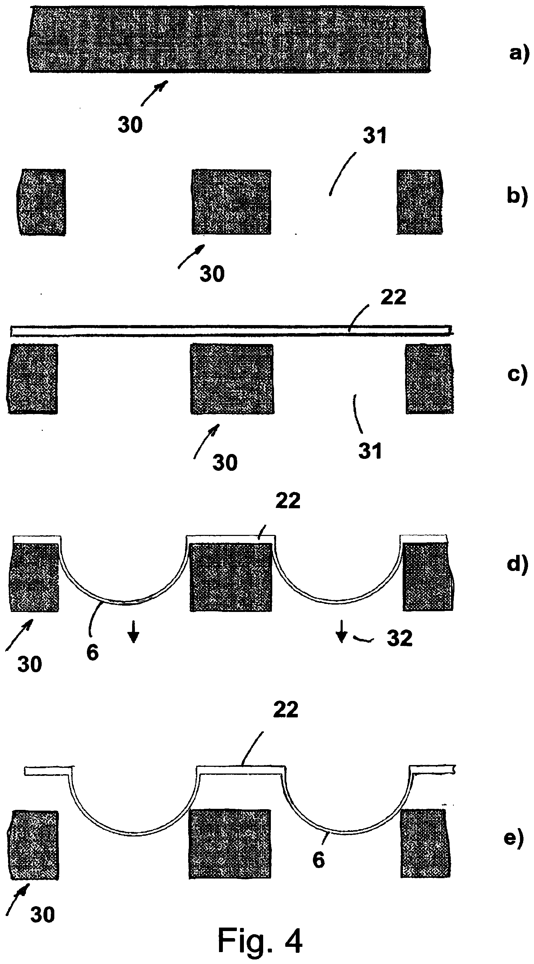

In Fig. 4 ist ein schematischer Prozessablauf zur Herstellung des Deckelwafers in einer Variante dargestellt, wobei eine Unterdruckformung auf einem wiederverwendbaren Werkzeug angewandt wird.

Gemäß Fig. 4a) ist ein unbehandeltes Werkzeug 30 vorgesehen, das nach Fig. 3b) mit Durchgangsöffnungen 31 versehen wird, die eine Grundfläche entsprechend der Grundfläche der zu erzeugenden Kuppeln aufweisen. Das Werkzeug kann aber auch von vornherein mit Durchgangsöffnungen zur Verfügung gestellt werden. Das Material des Werkzeugs ist ein hochtemperaturfester Stahl, Keramik oder Glas (Quarzglas) oder dgl., wobei das Material anschließend mit einer Beschichtung versehen wird, die ein Ankleben von heißem Glas auf dem Werkzeug verhindert, z.B. aus Bornitrid, Graphit, Diamant, amorphen Kohlenstoffschichten (DLC). Das Werkzeug kann aber auch selbst aus Materialen bestehen, die eine geringe Neigung zum Ankleben an Glas besitzen wie Bornitrid, SiC, Glaskohlenstoff, Diamant, Graphit oder dgl., wobei oftmals Graphit verwendet wird.

Nach Fig. 4c) wird ein Glaswafers bzw. Deckelwafer 22 auf das Werkzeug 30 aufgelegt und es wird von der Seite des Werkzeugs 30, die zu dem Deckelwafer 22 abgewandt ist, ein durch die Pfeile 32 angedeuteter Unterdruck angelegt, wobei dies durch eine angesetzte Unterdruckkammer geschehen kann. Auf der Seite des Deckelwafers herrscht atmosphärischer Druck.

Anschließend wird der gesamte Aufbau unter atmosphärischen Bedingungen getempert, wodurch das Glas des Deckelwafers 22 wird in die Öffnungen 31 hinein gesaugt wird und die Kuppeln 6 gebildet werden (Fig. 4d)). Dabei wird das Tempern so gesteuert, dass unter Berücksichtigung der Temperzeit und der Temperatur die Druckdifferenz zwischen dem atmosphärischen Druck und dem Unterdruck zum Ende des Prozesses hin abgesenkt wird. Der Herstellungsablauf des Decketwafers 22 wird beendet, wenn die erforderliche Höhe er Kuppeln 6 erreicht wird.

Der Deckelwafer 22 wird nach Belüften der Anordnung von dem Werkzeug 30 abgehoben, das bereit ist, den nächsten Wafer aufzunehmen (Fig. 4e)).

Die weiteren Schritte entsprechen denen in den Fign. 3f) und 3g).

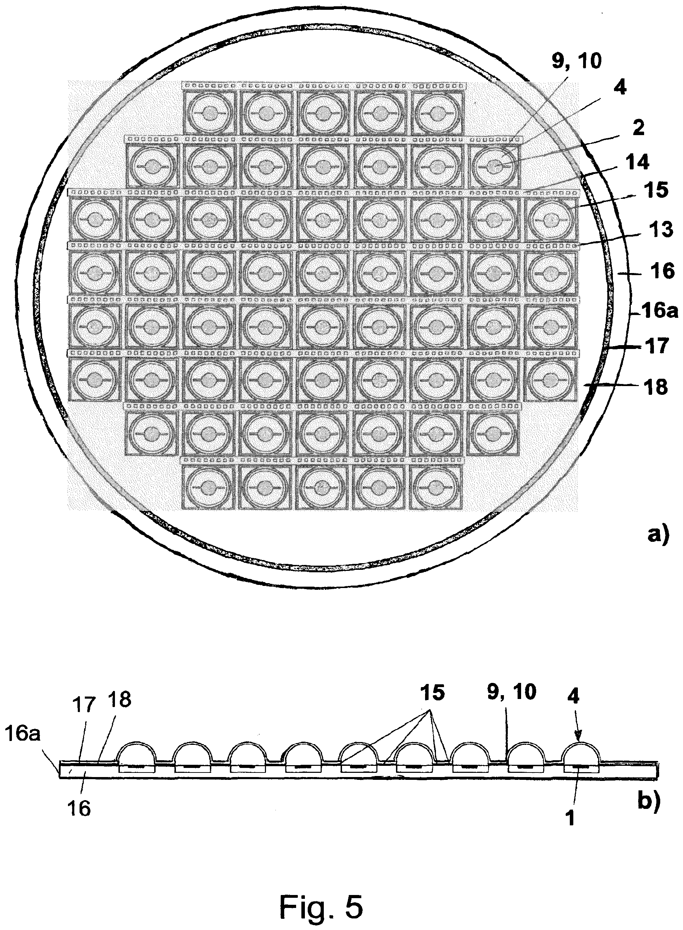

In den Fign. 5a) und 5b) ist eine Aufsicht auf und ein schematischer Schnitt durch einen Wafer 16 als Waferverbund mit einer Vielzahl von einzelnen Spiegelanordnungen, die in unterschiedliche Waferchips getrennt werden. die Spiegelanordnungen bzw. Waferchips sind auf dem runden Wafer 16 mit dem Waferrand 16a in parallelen Reihen angeordnet. Zwischen den Reihen liegen die zylindrischen Kuppeln 14 aus Glas über elektrischen Anschluss-Pads 13, die später, insbesondere für die Überprüfung der einzelnen Spiegelanordnungen auf dem Waferverbund geöffnet werden.

Anhand der Fig. 5a) kann der Vorgang des additiven Bondens erläutert werden. Um den jeweiligen Waferchip bzw. die Spiegelanordnung und um die Kuppel 6 herum ist ein Bondrahmen 15 aus einem Versiegelungsmaterial aufgebracht. Ein weiterer Bondrahmen 17 ist um den Umfang des Wafers 1, in der Regel aus Silizium, nahe seine Umfangsrandes 16a aufgebracht. Beim pneumatischen Bonden werden die Wafer am Umfang zunächst unter Vakuum miteinander verbunden. Dies geschieht, indem bei der Prozesstemperatur mit Hilfe eines zusätzlichen ringförmigen Werkzeugs nur in diesem Bereich lokal ein mechanischer Druck auf die Wafer ausgeübt wird. Dadurch werden die Wafer vor allem in diesem Bereich zusammengepresst und vakuumdicht versiegelt. Anschließend wird der Bonder mit einem Gas, meist Stickstoff, belüftet. Dabei presst der pneumatische Druck den evakuierten Bereich zwischen den beiden Wafern zusammen, so dass auch die Bondrahmen zwischen den einzelnen Chips zusammengepresst und miteinander verbunden werden. Erst danach werden die Wafer dem Bonder entnommen. Durch diesen zweistufigen Bondprozess können auch Wafer mit nicht planaren Oberflächen verarbeitet werden. Insbesondere entfällt dadurch auch die Notwendigkeit großflächig auf die Wafer einen mechanischen Druck auszuüben, was einen großen Vorteil darstellt, wenn empfindliche optische Oberflächen, wie im Fall der Kuppel verarbeitet werden müssen.

**Patentansprüche**

1. MEMS Spiegelanordnung zum Erfassen eines Winkelbereichs bis zu 180°, vorzugsweise bis zu 160°, umfassend:

    ein Trägersubstrat (1), an dem ein um mindestens eine Achse schwingender Spiegel (2) aufgehängt ist,
    einen transparenten Deckel (4), der mit dem Trägersubstrat (1) hermetisch dicht verbunden ist und der eine halbschalige Kuppel (6) mit einer ellipsoiden Querschnittsfläche, die sich über einer im Wesentlichen kreisförmigen Basisfläche erhebt, aufweist, wobei die Kuppel (6) mit einer Grenzflächen bildenden inneren Kuppelschale und äußeren Kuppelschale versehen ist und das Verhältnis der Höhe F zum Durchmesser D der inneren und/oder äußeren Kuppelschale zwischen 0,4 und 0,6 liegt und die Differenz zwischen dem Verhältnis der Höhe $F_i$ zum Durchmesser $D_i$ der inneren Kuppelschale und dem Verhältnis der Höhe $F_a$ zum Durchmesser $D_a$ der äußeren Kuppelschale zwischen $\pm 0,002$ liegt und
    eine Kompensationsoptik (8), die in einem vorgegebenen Strahlengang für ein einfallendes Strahlenbündel außerhalb der Kuppel (6) angeordnet ist,
    wobei die Mitte des Spiegels (2) mit dem Mittelpunkt der Basisfläche der Kuppel mit einer maximalen Toleranz von $\pm 20\%$ vom Durchmesser der Basisfläche der Kuppel übereinstimmt und
    wobei die Kompensationsoptik (8) das einfallende Strahlenbündel derart kollimiert, dass eine durch die Grenzflächen der Kuppel hervorgerufene Divergenz oder Konvergenz des Strahlenbündels nach dem Austritt aus der Kuppel (6) zumindest teilweise kompensiert ist.

2. MEMS Spiegelanordnung nach Anspruch 1, **dadurch gekennzeichnet, dass** die Differenz zwischen dem Verhältnis der Höhe $F_i$ zum Durchmesser $D_i$ der inneren Kuppelschale und dem Verhältnis der Höhe $F_a$ zum Durchmesser $D_a$ der äußeren Kuppelschale zwischen $\pm 0,001$ liegt.

3. MEMS Spiegelanordnung nach einem der Ansprüche 1 bis 2, **dadurch gekennzeichnet, dass** ein Verhältnis des Quadrats des Radius der Kuppel (6) zu der Dicke der Wand der Kuppel größer als 50 ist, $R^2/d > 50$.

4. MEMS Spiegelanordnung nach einem der Ansprüche 1 bis 3, **dadurch gekennzeichnet, dass** die Dicke der Wand der Kuppel (6) kleiner als 10% des Durchmessers der Basisfläche der Kuppel ist und/oder dass der Durchmesser des Spiegels zwischen 80% und 5% des Durchmessers der Basisfläche der Kuppel liegt.

5. MEMS Spiegelanordnung nach einem der Ansprüche 1 bis 6, **dadurch gekennzeichnet, dass** das Material der Kuppel (6) einen thermischen Ausdehnungskoeffizienten aufweist, der an den thermischen Ausdehnungskoeffizienten des Materials des Spiegels (2) angepasst ist.

6. MEMS Spiegelanordnung nach einem der Ansprüche 1 bis 7, **dadurch gekennzeichnet, dass** der den Spiegel (2) aufnehmende Innenraum zwischen Kuppel (6) und Trägersubstrat (1) unter Vakuum steht oder mit einem Schutzgas gefüllt ist.

7. MEMS Spiegelanordnung nach einem der Ansprüche 1 bis 8, **dadurch gekennzeichnet, dass** die Brennweite der Kuppel (6) näherungsweise und mit umgekehrten Vorzeichen der Brennweite der Kompensationsoptik (8) entspricht und/oder.
    dass die Brennweite der Kuppel zwischen -50 mm und -300 mm liegt.

8. Verfahren zur Herstellung einer MEMS Spiegelanordnung nach einem der Ansprüche 1-7, mit folgenden Schritten:

    a) Bereitstellen eines Siliziumwafers (20),
    b) Strukturieren des Silizumwafers (20) derart, dass eine Mehrzahl von Vertiefungen (21) hergestellt werden,
    c) Aufbonden eines Deckelwafers (22) aus glasartigem Material auf den strukturierten Siliziumwafer (20), wobei ein Inertgas bei einem vorgegebenen Druck in den durch die Vertiefungen (21) und den Deckelwafer (22) gebildeten Kavitäten eingeschlossen wird,
    d) Tempern des Verbundes aus Siliziumwafer (20) und Deckelwafer (22) derart, dass durch die Expansion des eingeschlossenen Inertgases eine Mehrzahl von Kuppeln (6) gebildet wird,
    e) nach Abkühlen des Verbundes aus Siliziumwafer (20) und Deckelwafer (22) teilweises oder vollständiges Entfernen des Siliziumwafers (20),

f) Anordnen eines Spiegelwafers (24), der eine Mehrzahl von am Trägersubstrat (1) aufgehängten Spiegeln (2) umfasst, zu dem Deckelwafer (22) derart, dass die Spiegelmitten jeweils im Mittelpunkt der Kuppeln (6) liegen,
g) Fügen und hermetisch dichtes Verschließen des Deckelwafers (22) mit dem Spiegelwafer (24) durch Bonden mit additiv aufgebrachten Schichten oder Strukturen,
h) Vereinzeln des Verbundes aus Deckelwafer (22) und Spiegelwafer (24) in einzelne verkappte MEMS Spiegelanordnungen,
i) Anordnen einer Kompensationsoptik (8) außerhalb des als Kuppel (6) ausgebildeten Deckels (4) im Strahlengang eines in die Kuppel einfallenden Strahles, wobei die Kompensationsoptik (8) eine Divergenz oder Konvergenz, die durch den Durchtritt des Strahles durch die äußeren und inneren Grenzflächen der Kuppel (6) hervorgerufen wird, zumindest teilweise kompensiert.

9. Verfahren zur Herstellung einer MEMS Spiegelanordnung nacheinem der Ansprüche 1-7, mit folgenden Schritten:

a) Bereitstellen eines Werkzeugs, das aus einem ein Ankleben eines heißen glasartigen Materials verhindernden Material besteht oder das mit einem ein Ankleben eines heißen glasartigen Materials verhindernden Material beschichtet ist,
b) vor oder nach dem Bereitstellen Versehen des Werkzeugs mit Durchgangsöffnungen,
c) Auflegen eines Deckelwafers (22) aus glasartigem Material auf das mit Durchgangsöffnungen versehene Werkzeug, wobei ein Unterdruck auf der vom Deckelwafer abgewandten Seite angelegt wird,
d) Tempern des Verbundes aus Werkzeug und Deckelwafer (22) bei atmosphärischen Bedingungen derart, dass durch Ansaugen des Deckelwafers in die Durchgangsöffnungen eine Mehrzahl von Kuppeln (6) gebildet wird,
e) nach Abkühlen des Verbundes aus Werkzeug und Deckelwafer (22) Entfernen des Werkzeugs,
f) Anordnen eines Spiegelwafers (24), der eine Mehrzahl von am Trägersubstrat (1) aufgehängten Spiegeln (2) umfasst, zu dem Deckelwafer (22) derart, dass die Spiegelmitten jeweils im Mittelpunkt der Kuppeln (6) liegen,
g) Fügen und hermetisch dichtes Verschließen des Deckelwafers (22) mit dem Spiegelwafer (24) durch Bonden mit zuvor aufgebrachten Schichten oder Strukturen,
h) Vereinzeln des Verbundes aus Deckelwafer (22) und Spiegelwafer (24) in einzelne verkappte MEMS Spiegelanordnungen,
i) Anordnen einer Kompensationsoptik (8) außerhalb des als Kuppel (6) ausgebildeten Deckels (4) im Strahlengang eines in die Kuppel einfallenden Strahles, wobei die Kompensationsoptik (8) eine Divergenz oder Konvergenz, die durch den Durchtritt des Strahles durch die äußeren und inneren Grenzflächen der Kuppel (6) hervorgerufen wird, zumindest teilweise kompensiert.

10. Verfahren nach Anspruch 8, **dadurch gekennzeichnet, dass** das Tempern unter Vakuum durchgeführt wird oder dass während des Abkühlens nach dem eigentlichen Tempervorgangs in einer Gasatmosphäre der Gasdruck innerhalb eines geschlossenen Ofens mit der Temperaturänderung entsprechend der thermischen Zustandsgleichung nachgeführt wird und/oder dass das Tempern unter Vakuum bei 650°-950°C, vorzugsweise bei 700° - 800°C, noch bevorzugter bei 710°C durchgeführt wird und nach einer definierten Zeit von 30 min - 12 Std., vorzugsweise etwa 2 Stunden beendet wird und unter Vakuum abgekühlt wird.

11. Verfahren nach einem der Ansprüche 8, 9, 10, **dadurch gekennzeichnet, dass** beim Aufbonden des Deckelwafers (22) auf den Siliziumwafer (20) das Inertgas bei einem Druck von 100 mbar bis 3 bar, vorzugsweise 1 bar bis 1,2 bar in den Kavitäten eingeschlossen wird.

12. Verfahren nach Anspruch 9,
**dadurch gekennzeichnet, dass** die Parameter Tiefe der Vertiefungen (21) des strukturierten Siliziumwafers (20), Druck des in den Kavitäten eingeschlossenen Gases, Temperatur des Temperns und Zeit des Temperns so gesteuert werden, dass gegen Ende des Temperns, vorzugsweise bei den letzten 20% der Temperzeit die Fließgeschwindigkeit des glasartigen Materials kleiner als 0,5 mm pro Stunde beträgt und/oder dass die Parameter Druckdifferenz zwischen dem atmosphärischen Druck und dem auf der vom Deckelwafer abgewandten Seite angelegten Druck sowie zeitlicher Verlauf der Druckdifferenz, Temperatur des Temperns und Zeit des Temperns so gesteuert werden, dass gegen Ende des Temperns, vorzugsweise bei den letzten 20% der Temperzeit die Fließgeschwindigkeit des glasartigen Materials kleiner als 0,5 mm pro Stunde beträgt.

13. Verfahren nach einem der vorhergehenden Ansprüche 8-12 **dadurch gekennzeichnet, dass** nach dem Tempern und Entfernen des Siliziumwafers (20) oder des Werkzeugs auf die Innen- und/oder Außenfläche der Kuppeln (6) eine Antireflexbeschichtung, vorzugsweise durch ein CVD oder ALD Verfahren aufgebracht wird.

**14.** Verfahren nach einem der Ansprüche 8 bis 12, **dadurch gekennzeichnet, dass** als Versiegelungsmaterial (23) beim Bonden ein aufdruckbares Versiegelungsmaterial, vorzugsweise ein schmelzfähiges Lot oder Glaslot verwendet wird.

**15.** Verfahren nach einem der Ansprüche 8 bis 14, **dadurch gekennzeichnet, dass** das Versiegelungsmaterial (23) an Fügezonen (5) zwischen Deckelwafer (22) und Spiegelwafer (24) aufgebracht wird, die zur Ableitung der Druckkräfte beim Bonden direkt unterhalb der Wandungen der Kuppeln liegen.

**16.** Verfahren nach einem der Ansprüche 8 bis 15, **dadurch gekennzeichnet, dass** beim Bonden des Deckelwafers (22) und des Spiegelwafers (24) die benötigten Druckkräfte punktuell oder linienförmig aufgebracht werden.

**17.** Verfahren nach einem der Ansprüche 8 bis 15, **dadurch gekennzeichnet, dass** beim Bonden der Deckelwafer (22) und der Spiegelwafer (24) an ihren Randbereichen dicht miteinander verbunden werden und dass anschließend die Bondung pneumatisch durchgeführt wird.

**Claims**

**1.** An MEMS mirror arrangement for detecting an angular range of up to 180°, preferably up to 160°, comprising:

a carrier substrate (1) on which a mirror (2) which oscillates about at least one axis is suspended,
a transparent cover (4) which is connected to the carrier substrate (1) in a hermetically sealed manner and which comprises a semi-shell dome (6) with an ellipsoidal cross-sectional surface, said dome rising above an essentially circular base surface, wherein the dome (6) is provided with an inner dome shell and an outer dome shell which form boundary surfaces and the ratio of the height F to the diameter D of the inner and/or outer dome shell is between 0.4 and 0.6 and the difference between the ratio of the height $F_i$ to the diameter $D_i$ of the inner dome shell and the ratio of the height $F_a$ of to the diameter $D_a$ of the outer dome shell is within $\pm 0.002$, and compensation optics (8) which are arranged outside the dome (6) in a predefined beam path for an incident beam bundle,
wherein the middle of the mirror (2) coincides with the middle point of the base surface of the dome with a maximum tolerance of $\pm 20\%$ of the diameter of the base surface of the dome and
wherein the compensation optics (8) collimate the incident beam bundle in a manner such that a divergence or convergence of the beam bundle, caused by the boundary surfaces of the dome, is at least partly compensated after exit from the dome (6).

**2.** An MEMS mirror arrangement according to claim 1, **characterised in that** the difference between the ratio of the height $F_i$ to the diameter $D_i$ of the inner dome shell and the ratio of the height $F_a$ to the diameter $D_a$ of the outer dome shell is within $\pm 0.001$.

**3.** An MEMS mirror arrangement according to one of the claims 1 to 2, **characterised in that** a ratio of the square of the dome (6) to the thickness of the wall of the dome is larger than 50, $R^2/d > 50$.

**4.** An MEMS mirror arrangement according to one of the claims 1 to 3, **characterised in that** the thickness of the wall of the dome (6) is less than 10% of the diameter of the base surface of the dome and/or that the diameter of the mirror is between 80% and 5% of the diameter the base surface of the dome.

**5.** An MEMS mirror arrangement according to one of the claims 1 to 6, **characterised in that** the material of the dome (6) has a thermal coefficient of expansion which is adapted to the thermal coefficient of expansion of the material of the mirror (2).

**6.** An MEMS mirror arrangement according to one of the claims 1 to 7, **characterised in that** the inner space between the dome (6) and the carrier substrate (1), said inner space receiving the mirror (2), is under a vacuum or is filled with a protective gas.

**7.** An MEMS mirror arrangement according to one of the claims 1 to 8, **characterised in that** the focal length of the dome (6) corresponds approximately to and with the opposite sign of the focal width of the compensation optics (8) and/or
that the focal length of the dome is between -50 mm and -300 mm.

8. A method for manufacturing an MEMS mirror arrangement according to one of the claims 1-7, with the following steps:

a) providing a silicon wafer (20),
b) structuring the silicon wafer (20) in a manner such that a plurality of deepenings (21) is created,
c) bonding a cover wafer (22) of glass-like material onto the structured silicon wafer (20), wherein an inert gas is enclosed at a predefined pressure in the cavities which are formed by the deepenings (21) and the cover wafer (22),
d) tempering the composite of the silicon wafer (20) and of the cover wafer (22) in a manner such that a plurality of domes (6) is formed by way of the expansion of the enclosed inert gas,
e) after cooling the composite of the silicon wafer (20) and the cover wafer (22), partial or complete removal of the silicon wafer (20),
f) arranging a mirror wafer (24) which comprises a plurality of mirrors (2) which are suspended on the carrier substrate (1), with respect to the cover wafer (22) in a manner such that the mirror middles each lie in the middle point of the domes (6),
g) joining and hermetically sealed closing of the cover wafer (22) with the mirror wafer (24) by way of bonding with additively deposited layers or structures,
h) singularising the composite of cover wafer (22) and mirror wafer (24) into individually capped MEMS mirror arrangements,
i) An arrangement of compensation optics (8) outside the cover (4) designed as a dome (6) in the beam path of a beam incident on the dome, said compensation optics (8) at least partly compensating a divergence or convergence which is caused by the passage of the beam through the outer and inner boundary surfaces of the dome (6).

9. A method for manufacturing an MEMS mirror arrangement according to one of the claims 1-7, with the following steps:

a) providing a tool which consists of a material which prevents an adhesion of a hot, glass-like material or is coated with a material which prevents an adhesion of a hot, glass-like material,
b) providing the tool with through-openings before or after the provision,
c) laying the cover wafer (22) of glass-like material onto the tool which is provided with through-openings, wherein a negative pressure is applied at the side which is away from the cover wafer,
d) tempering the composite of the tool and of the cover wafer (22) under atmospheric conditions in a manner such that a plurality of domes (6) is formed by way of the sucking of the cover wafer into the through-openings,
e) after cooling the composite of the tool and the cover wafer (22), removal of the tool,
f) arranging a mirror wafer (24) which comprises a plurality of mirrors (2) which are suspended on the carrier substrate (1), with respect to the cover wafer (22) in a manner such that the mirror middles each lie in the middle point of the domes (6),
g) joining and hermetically sealed closing of the cover wafer (22) with the mirror wafer (24) by way of bonding with previously deposited layers or structures,
h) singularising the composite of cover wafer (22) and mirror wafer (24) into individually capped MEMS mirror arrangements,
i) An arrangement of compensation optics (8) outside the cover (4) designed as a dome (6) in the beam path of a beam incident on the dome, said compensation optics (8) at least partly compensating a divergence or convergence which is caused by the passage of the beam through the outer and inner boundary surfaces of the dome (6).

10. A method according to claim 8, **characterised in that** the tempering is carried out under a vacuum or that during the cooling after the actual tempering procedure in a gas atmosphere, the gas pressure within a closed oven is tracked to the temperature change according to the thermal equation of state and/or that the tempering under vacuum is carried out at 650°-950°C, preferably at 700°-800°C, more preferably at 710°C and is terminated after a defined time of 30 min-12 hours, preferably about 2 hours and is cooled under vacuum.

11. A method according to one of the claims 8, 9, 10, **characterised in that** the inert gas is enclosed in the cavities at a pressure of 100 mbar to 3 bar, preferably 1 bar to 1.2 bar on bonding the cover wafer (22) onto the silicon wafer (20).

12. A method according to claim 9, **characterised in that** the parameters depth of the deepenings (21) of the structured silicon wafer (20), pressure of the gas enclosed in the cavities, temperature of the tempering and time of the tempering are controlled such that the flow speed of the glass-like material is smaller than 0.5 mm per hour towards the end of the tempering, preferably during the last 20% of the tempering time and/or that the parameter differential pressure between the atmospheric pressure and the pressure which is applied at the side facing away from the cover wafer as well as the temporal course of the pressure difference, the temperature of the tempering and the time of the tempering are controlled such that the flow speed of the glass-like material is smaller than 0.5 mm per hour towards the end of the tempering, preferably during the last 20% of the tempering time.

13. A method according to one of the claims 8-12, **characterised in that** an anti-reflex coating is deposited onto the inner and/or outer surface of the domes (6) after the tempering and removal of the silicon wafer (20) or of the tool, preferably by way of a CVD or ALD method.

14. A method according to one of the claims 8 to 12, **characterised in that** a printable sealing material, preferably a meltable solder or glass solder is used as a sealing material (23) on bonding.

15. A method according to one of the claims 8 to 14, **characterised in that** the sealing material (23) is deposited on joining zones (5) between the cover wafer (22) and the mirror wafer (24), said joining zones lying directly below the walls of the domes for leading away pressure forces on bonding.

16. A method according to one of the claims 8 to 15, **characterised in that** the necessary pressure forces are exerted in a pointwise or linear manner on bonding the cover wafer (22) and the mirror wafer (24).

17. A method according to one of the claims 8 to 15, **characterised in that** the cover wafer (22) and the mirror wafer (24) are connected to one another in a sealed manner at their edge regions on bonding and that the bonding is subsequently carried out pneumatically.

**Revendications**

1. Ensemble de miroirs MEMS permettant la détection d'une zone angulaire jusqu'à 180 °, de préférence jusqu'à 160 °, comprenant :

   un support de substrat (1), sur lequel est suspendu un miroir (2) oscillant autour d'au moins un axe,
   un couvercle (4) transparent, qui est relié de manière hermétiquement étanche avec le support de substrat (1) et qui présente une coupole en demi-coque (6) avec une surface de section transversale ellipsoïde, qui s'élève au-dessus d'une surface de base de forme essentiellement circulaire, où la coupole (6) est munie d'une coque de coupole intérieure formant une surface de délimitation et d'une coque de coupole extérieure, et le rapport de la hauteur F sur le diamètre D de la coque de coupole intérieure et/ou extérieure se situe entre 0,4 et 0,6 et la différence entre le rapport de la hauteur $F_i$ sur le diamètre $D_i$ de la coque de coupole intérieure et le rapport de la hauteur $F_a$ sur le diamètre $D_a$ de la coque de coupole extérieure se situe à $\pm$ 0,002, et
   une optique de compensation (8), qui est disposée dans un trajet de rayonnement prédéfini pour un faisceau de rayons incident extérieur à la coupole (6),
   dans lequel le milieu du miroir (2) correspond au centre de la surface de base de la coupole avec une tolérance maximale de $\pm$ 20 % par rapport au diamètre de la surface de base de la coupole, et
   dans lequel l'optique de compensation (8) collimate le faisceau de rayons incident de telle manière qu'une divergence ou une convergence du faisceau de rayons induites par la surface de délimitation de la coupole est compensée au moins partiellement après la sortie de la coupole (6).

2. Ensemble de miroirs MEMS selon la revendication 1, **caractérisé en ce que** la différence entre le rapport de la hauteur $F_i$ sur le diamètre $D_i$ de la coque de coupole intérieure et le rapport de la hauteur $F_a$ sur le diamètre $D_a$ de la coque de coupole extérieure se situe à $\pm$ 0,001.

3. Ensemble de miroirs MEMS selon l'une des revendications 1 à 2, **caractérisé en ce qu'**un rapport du carré du rayon de la coupole (6) sur l'épaisseur de la paroi de la coupole est supérieur à 50, $R^2/d > 50$.

4. Ensemble de miroirs MEMS selon l'une des revendications 1 à 3, **caractérisé en ce que** l'épaisseur de la paroi de la coupole (6) est inférieure à 10 % du diamètre de la surface de base de la coupole, et/ou que le diamètre du miroir est entre 80 % et 5 % du diamètre de la surface de base de la coupole.

5. Ensemble de miroirs MEMS selon l'une des revendications 1 à 6, **caractérisé en ce que** la matière de la coupole (6) présente un coefficient de dilatation thermique qui est adapté au coefficient de dilatation thermique de la matière du miroir (2).

6. Ensemble de miroirs MEMS selon l'une des revendications 1 à 7, **caractérisé en ce que** l'espace intérieur réceptionnant le miroir (2) est placé sous vide ou est rempli avec un gaz de protection entre la coupole (6) et le support de substrat (1).

7. Ensemble de miroirs MEMS selon l'une des revendications 1 à 8, **caractérisé en ce que** la distance focale de la coupole (6) correspond à peu près et avec un signe inverse à la distance focale de l'optique de compensation (8), et/ou **que** la distance focale de la coupole se situe entre -50 mm et - 300 mm.

8. Procédé d'élaboration d'un ensemble de miroirs MEMS selon l'une des revendications 1 à 7, avec les étapes suivantes :

a) préparation d'une tranche de silicium (20),
b) structuration de la tranche de silicium (20) de telle manière qu'une multiplicité de vides (21) soit créée,
c) création d'une liaison au-dessus de la tranche de silicium (20) structurée avec une tranche de recouvrement (22) à base d'une matière de type vitreux, où un gaz inerte est emprisonné sous une pression définie dans les cavités formées par les vides (21) et la tranche de recouvrement (22),
d) trempe du composite à base de la tranche de silicium (20) et de la tranche de recouvrement (22) de telle manière qu'une multiplicité de coupoles (6) soit formée par l'expansion du gaz inerte emprisonné,
e) après le refroidissement du composite à base de la tranche de silicium (20) et de la tranche de recouvrement (22), retrait partiel ou total de la tranche de silicium (20),
f) disposition d'une tranche de miroirs (24), qui comprend une multiplicité de miroirs (2) suspendus sur le support de substrat (1), près de la tranche de recouvrement (22) de telle manière que les centres des miroirs se situent respectivement aux milieux des coupoles (6),
g) assemblage et fermeture hermétique étanche de la tranche de recouvrement (22) avec la tranche de miroirs (24) par la liaison avec des couches ou des structures rapportées de manière additive,
h) division du composite à base de la tranche de recouvrement (22) et de la tranche de miroirs (24) en ensembles de miroirs MEMS recouverts individuels,
i) disposition d'une optique de compensation (8) à l'extérieur du couvercle (4) conçu sous forme de coupole (6) dans le trajet des rayons d'un rayonnement tombant dans la coupole, où l'optique de compensation (8) compense au moins partiellement une divergence ou une convergence qui est induite par le passage du rayonnement à travers les surfaces de délimitation intérieure et extérieure de la coupole (6).

9. Procédé d'élaboration d'un ensemble de miroirs MEMS selon l'une des revendications 1 à 7, avec les étapes suivantes :

a) préparation d'un outil qui est constitué d'une matière empêchant l'adhésion d'une matière chaude de type vitreux ou qui est revêtue d'une matière empêchant une adhésion d'une matière chaude de type vitreux,
b) avant ou après la préparation, la mise en place d'orifices de passage dans l'outil,
c) dépôt d'une tranche de recouvrement (22) à base d'une matière de type vitreux sur l'outil pourvu d'orifices de passage, où une dépression est appliquée à partir du côté opposé à la tranche de recouvrement,
d) trempe du composite à base de l'outil et de la tranche de recouvrement (22) dans des conditions atmosphériques telles qu'une multiplicité de coupoles (6) soit formée par l'aspiration de la tranche de recouvrement dans les orifices de passage,
e) après le refroidissement du composite à base de l'outil et de la tranche de recouvrement (22), retrait de l'outil,
f) disposition d'une tranche de miroirs (24), qui comprend une multiplicité de miroirs (2) suspendus sur le support de substrat (1), près de la tranche de recouvrement (22) de telle manière que les centres des miroirs se situent respectivement aux milieux des coupoles (6),
g) assemblage et fermeture hermétiquement étanche de la tranche de recouvrement (22) avec la tranche de miroirs (24) par la liaison avec des couches ou des structures rapportées auparavant par liaison,
h) division du composite à base de la tranche de recouvrement (22) et de la tranche de miroirs (24) en ensembles de miroirs MEMS recouverts individuels,
i) disposition d'une optique de compensation (8) à l'extérieur du couvercle (4) conçu sous forme de coupole (6) dans le trajet des rayons d'un rayonnement tombant dans la coupole, où l'optique de compensation (8) compense au moins partiellement une divergence ou une convergence qui est induite par le passage du rayonnement à travers les surfaces de délimitation intérieure et extérieure de la coupole (6).

**10.** Procédé selon la revendication 8, **caractérisé en ce que** la trempe est effectuée sous vide ou que, pendant le refroidissement, après le processus de trempe réel dans une atmosphère gazeuse, la pression de gaz à l'intérieur d'un four fermé est reproduite avec la variation de température correspondant à l'équilibre d'état thermique, et/ou que la trempe est effectuée sous vide de 650 ° à 950 °C, de préférence de 700 ° à 800 °C, de manière encore préférée à 710 °C et est terminée après une durée définie de 30 minutes à 12 heures, de préférence d'environ 2 heures, et est refroidi sous vide.

**11.** Procédé selon l'une des revendications 8, 9,10, **caractérisé en ce que**, lors de la liaison sur la tranche de recouvrement (22) sur la tranche de silicium (20), le gaz inerte est emprisonné dans les cavités avec une pression de 100 mbar à 3 bar, de préférence de 1 bar à 1,2 bar.

**12.** Procédé selon la revendication 9, **caractérisé en ce que** les paramètres profondeur des vides (21) de la tranche de silicium (20) structurée, pression du gaz emprisonné dans les cavités, température et durée de la trempe, sont commandés de telle manière que, vers la fin de la trempe, de préférence pendant les derniers 20 % de la durée de la trempe, la vitesse d'écoulement de la matière de type vitreux est inférieure à 0,5 mm par heure, et/ou que les paramètres différence de pression entre la pression atmosphérique et la pression appliquée sur le côté opposé à la tranche de recouvrement ainsi que l'évolution dans le temps de la différence de pression, la température de la trempe et la durée de la trempe sont commandés de telle manière que, vers la fin de la trempe, de préférence pendant les derniers 20 % de la durée de la trempe, la vitesse d'écoulement de la matière de type vitreux est inférieure à 0,5 mm par heure.

**13.** Procédé selon l'une des revendications précédentes 8 à 12, **caractérisé en ce qu'**après la trempe et le retrait de la tranche de silicium (20) ou de l'outil, un revêtement antireflets est rapporté sur la surface intérieure et/ou extérieure des coupoles (6), de préférence par un procédé dépôt chimique en phase vapeur ou un procédé de dépôt de couches minces atomiques.

**14.** Procédé selon l'une des revendications 8 à 12, **caractérisé en ce qu'**en tant que matière d'obturation (23) lors de la liaison une matière d'obturation applicable par pression, on emploie de préférence un produit de soudure fusible ou un produit de soudure en vitreux.

**15.** Procédé selon l'une des revendications 8 à 14, **caractérisé en ce que** la matière d'obturation (23) est rapportée sur des zones de jointement (5) entre la tranche de revêtement (22) et la tranche de miroirs (24) qui se situent directement en-dessous des parois des coupoles pour la dérivation des forces de traction lors de la liaison.

**16.** Procédé selon l'une des revendications 8 à 15, **caractérisé en ce que**, lors de la liaison de la tranche de recouvrement (22) et de la tranche de miroirs (24), les forces de pression nécessaires sont appliquées ponctuellement ou en forme de lignes.

**17.** Procédé selon l'une des revendications 8 à 15, **caractérisé en ce que**, lors de la liaison, la tranche de recouvrement (22) et de la tranche de miroirs (24) sont reliées l'une à l'autre de manière étanche au niveau de leurs zones de bord et qu'ensuite la liaison est effectuée de manière pneumatique.

Fig. 1

Fig. 2

**Fig. 3**

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011119610
- US 8151600 B
- CN 101734612 A